# EUROPÄISCHE PATENTANMELDUNG

(11) **EP 4 839 077 A1**
(43) Veröffentlichungstag der Anmeldung: **11.11.2026**
(21) Anmeldenummer: 26174104.5
(22) Anmeldetag: 22.04.2026
(51) Int. Cl.: H10W 70/62, H01R 12/57, H10W 72/50, H10W 90/00, H01R 4/02, H01R 12/52, H10W 72/20

(54) **SOCKELELEMENT ZUR SIGNALKONTAKTIERUNG IN EINEM LEISTUNGSMODUL SOWIE LEISTUNGSELEKTRONISCHES BAUTEIL MIT MINDESTENS EINEM SOLCHEN SOCKELELEMENT**

(30) Priorität: 06.05.2025 DE 102025117364
(71) Anmelder: Volkswagen Aktiengesellschaft, 38440 Wolfsburg (DE)
(72) Erfinder: Zimmermann, Matthias, 38440 Wolfsburg (DE); Lieker, Stephan, 38440 Wolfsburg (DE); Bayer, Dr. Christoph Friedrich, 38440 Wolfsburg (DE); Pieper, Dr. Sven, 38440 Wolfsburg (DE); Michelsen, Steffen, 38440 Wolfsburg (DE); Holverscheid, Joshua, 38440 Wolfsburg (DE); Rang, Oliver, 38440 Wolfsburg (DE)

(57) **Zusammenfassung**

Die Erfindung betrifft ein Sockelelement (10) zur Signalkontaktierung in einem leistungselektronischen Bauteil (32). Das Sockelelement (10) weist einen Schaftabschnitt (12) und einen endseitig radial auskragenden Pilzkopfabschnitt (14) auf. Das Sockelelement (10) ist aus mindestens zwei Teilelementen und/oder aus mindestens zwei Werkstoffen gefertigt.

## Beschreibung

Die Erfindung betrifft ein Sockelelement zur Signalkontaktierung in einem Leistungsmodul sowie ein leistungselektronisches Bauteil mit mindestens einem solchen Sockelelement. Insbesondere betrifft die Erfindung Sockelelemente, die der Signalweiterleitung innerhalb eines leistungselektronischen Bauteils dienen und/oder die die Signalausleitung von einem Substrat aus nach außen zu einer anderen Ebene eines leistungselektronischen Bauteils ermöglichen, insbesondere aus einem Substrat, das mit meiner Vergussmasse (auch als Moldmasse bezeichnet) umgeben ist, nach außen zu einem printed circuit board (PCB).

Aus EP 4 258 832 A1 ist ein Leistungsmodul bekannt, das zylindrische Elemente aufweist, die zum Herstellen einer elektrisch leitenden Verbindung zwecks Ausleitung von Signalen aus dem Leistungsmodul ermöglichen. Dabei sind Varianten zum Bonden, zum Einstecken und zum Einschrauben offenbart. Alle beschriebenen und gezeigten Varianten stellen eine elektrisch leitfähige Verbindung her und haben den Nachteil, dass mit den zylindrischen Elementen keine weiteren Funktionen bereitgestellt werden können.

Der Erfindung liegt die Aufgabe zugrunde, ein Sockelelement zur Signalkontaktierung in einem Leistungsmodul sowie ein leistungselektronisches Bauteil mit mindestens einem solchen Sockelelement zur Verfügung zu stellen, dessen Funktionalität verbessert ist, insbesondere um eine bauraumsparende Grundfläche eines Leistungsmoduls zu ermöglichen.

Die Lösung der Aufgabe erfolgt erfindungsgemäß mit den Merkmalen der unabhängigen Ansprüche. Weitere praktische Ausführungsformen und Vorteile der Erfindung sind in Verbindung mit den abhängigen Ansprüchen beschrieben.

Nachfolgend werden einige im Rahmen dieser Anmeldung verwendete Definitionen erläutert.

Unter dem Begriff "leistungselektronisches Bauteil" kann im Sinne der Erfindung ein Leistungsmodul verstanden werden. Beispielsweise handelt es sich bei dem Leistungsmodul um eine leistungselektronische Halbbrücke, die dazu geeignet ist, durch Schaltvorgänge aus einer Gleichspannung eine Wechselspannung zu erzeugen und umgekehrt.

Unter dem Begriff "Sockelelement" kann im Sinne dieser Erfindung ein Element verstanden werden, das von einer Substratebene bzw. einem Schaltungsträger zu einer anderen Ebene führt, um Signale aus- oder weiterzuleiten.

Unter dem Begriff "Grundfläche eines Leistungsmoduls" kann im Sinne dieser Erfindung ein Substrat verstanden werden, auf dem eine Schaltungsanordnung angeordnet bzw. ausgebildet ist. Diese auch als Schaltungsträger bezeichnete Grundfläche kann vorzugsweise auch von einer Vergussmasse umschlossen sein.

Unter dem Begriff "Signalweiterleitung" kann im Sinne dieser Erfindung eine elektrisch leitende Verbindung innerhalb des gleichen leistungselektronischen Bauteils verstanden werden, das üblicherweise von einer Vergussmasse umschlossen ist.

Unter dem Begriff "Ausleitfläche" kann im Sinne dieser Erfindung eine obere Stirnfläche des Hutelements verstanden werden, die vorzugsweise eine Fläche von 3-5 mm² aufweist.

Unter dem Begriff "Verteilebene" kann im Sinne dieser Erfindung eine mittlere oder obere Ebene des leistungselektronischen Bauteils verstanden werden, die dazu dient, elektrische Verbindungen in horizontaler Richtung herzustellen, insbesondere zur Signalweiterleitung
Unter dem Begriff "Aufstandsfläche" kann im Sinne dieser Erfindung eine Fläche verstanden werden, auf der das Sockelelement angeordnet ist. Die Aufstandsfläche ist vorzugsweise eine plane Fläche. Die Verbindung des Sockelelements mit der Aufstandsfläche erfolgt insbesondere mittels Ultraschallschweißen oder Löten.

Das erfindungsgemäße Sockelelement zur Signalkontaktierung in einem leistungselektronischen Bauteil weist einen Schaftabschnitt und einen endseitig radial auskragenden Pilzkopfabschnitt auf. Ferner ist das Sockelelement aus mindestens zwei Teilelementen und/oder aus mindestens zwei Werkstoffen gefertigt. Vorzugsweise ist der Schaftabschnitt zumindest bereichsweise zylindrisch oder vollständig zylindrisch ausgebildet. Der Schaftabschnitt kann alternativ jedoch auch zumindest bereichsweise prismatisch oder vollständig prismatisch ausgebildet sein. Weiterhin alternativ kann der Schaftabschnitt in Teilbereichen oder vollständig auch andere geometrische Ausgestaltungen aufweisen, solange diese für die Erfindung zweckmäßig sind. Im weiteren Verlauf der Anmeldung wird der Schaftabschnitt am Beispiel eines zylindrischen Schaftabschnitts beschrieben. Es versteht sich jedoch von selbst, dass die weiteren Ausführungen für anders ausgebildete Schaftabschnitte analog gelten.

Ein Sockelelement, das aus mindestens zwei Teilelementen oder aus zwei verschiedenen Werkstoffen gefertigt ist, bietet mehrere Vorteile in Bezug auf die Funktionalität und die Anpassungsfähigkeit an verschiedene Anforderungen in leistungselektronischen Anwendungen. Durch die Aufteilung in mindestens zwei Teilelemente und/oder die Fertigung aus zwei Werkstoffen kann das Sockelelement gezielt so gestaltet werden, dass mechanische, thermische und elektrische Eigenschaften optimiert werden. Beispielsweise kann ein Teilelement oder auch nur eine Beschichtung eines Elements aus einem elektrisch leitfähigen Material gefertigt sein, um eine effiziente Stromübertragung sicherzustellen, während ein anderes Teilelement oder auch nur eine Beschichtung eines Elements aus einem wärmeleitfähigen, aber elektrisch isolierenden Material gefertigt ist, um eine gezielte Wärmeabfuhr zu ermöglichen und/oder elektrische Isolationseigenschaften zu gewährleisten. Dies verbessert die Gesamtleistung und erhöht die Lebensdauer des Leistungsmoduls, da thermische Belastungen reduziert werden.

Ein weiterer Vorteil eines mehrteilig hergestellten Sockelelements besteht darin, dass die Teilelemente mit verschiedenen Fertigungsverfahren hergestellt sein und daher eine hochfunktionale Gestaltung aufweisen können. Dadurch können eine kosteneffiziente Produktion und/oder eine größere Designfreiheit oder Funktionsvielfalt ermöglicht werden. Beispielsweise kann ein präzise gefertigter, metallischer Kontaktbereich, insbesondere ein Hutabschnitt und/oder ein Pilzkopfabschnitt, durch ein anderes Verfahren gefertigt werden als ein mechanisch hochfestes Tragelement, insbesondere ein Schaftbereich, aus Kunststoff oder Keramik.

Darüber hinaus erlaubt eine modulare Bauweise eine größere Variabilität bei der Anpassung an unterschiedliche Leistungsmodule und Einsatzszenarien. So können einzelne Teilelemente des Sockels je nach Anwendungsfall ausgetauscht oder durch alternative Materialien ersetzt werden, um spezifische Anforderungen zu erfüllen. Dies führt zu einer flexibleren Nutzung des Sockelelements in verschiedenen Leistungselektroniksystemen.

Des Weiteren erlaubt der Pilzkopfabschnitt die elektrische Kontaktierung mehrerer Signalleitungen, wodurch eine einfache und effiziente Signalweiterleitung erreicht werden kann.

Insgesamt verbessert eine Konstruktion aus mindestens zwei Teilelementen oder zwei Werkstoffen die elektrische und thermische Leistungsfähigkeit, die mechanische Stabilität sowie die Variabilität des Sockelelements und trägt damit zu einer gesteigerten Funktionssicherheit und Effizienz des gesamten leistungselektronischen Bauteils bei.

Das Sockelelement weist vorzugsweise eine Höhe und/oder einen Durchmesser von 3-10 mm, weiter bevorzugt von 3-5 mm auf.

Gemäß einer praktischen Ausführungsform sind zwei oder drei Teilelemente separat hergestellt und fest miteinander verbunden. Diese Ausführungsform bietet Vorteile hinsichtlich einer höheren Designfreiheit, optimierter Fertigungsprozesse, einer gezielten Materialauswahl und einer verbesserten mechanischen und thermischen Leistungsfähigkeit. Dies führt insgesamt zu einer verbesserten Funktionalität und Langlebigkeit des Sockelelements, wodurch es sich besonders gut für leistungselektronische Anwendungen eignet.

Von Vorteil kann es ferner sein, wenn gemäß einer praktischen Ausführungsform ein Teilelement einen zylindrischer Schaftabschnitt umfasst, insbesondere wenn ein Teilelement nur aus dem zylindrischen Schaftabschnitt gebildet ist, und mindestens ein weiteres Teilelement auf ein Ende des zylindrischen Schaftabschnitts aufgesteckt ist. Das Aufstecken kann hierbei bevorzugt nach Art einer Clip-Verbindung durch eine kraftschlüssige und/oder formschlüssige Verbindung erfolgen. Die Kombination aus einem zylindrischen Schaftabschnitt und einem aufgesteckten Teilelement bietet eine flexible, robuste und kosteneffiziente Lösung für leistungselektronische Anwendungen. Sie erleichtert die Montage und ermöglicht eine weiter verbesserte modulare Bauweise für unterschiedliche Einsatzbereiche.

In einer praktischen Ausführungsform ist ein Teilelement als separates Hutelement ausgebildet und zumindest bereichsweise um einen Pilzkopfabschnitt eines anderen Teilelements umklammernd angeordnet. Die Kombination eines Hutelements mit einem Pilzkopfabschnitt bietet eine robuste, langlebige und anpassungsfähige Lösung für ein Sockelelement. Sie verbessert die mechanische Stabilität, die elektrische Kontaktierung und die Wärmeableitung, während gleichzeitig durch die umklammernde Anordnung des Hutelements eine einfache Montage und Wartung gewährleistet wird. Diese Eigenschaften machen sie besonders vorteilhaft für Anwendungen in der Leistungselektronik, wo hohe Ströme, thermische Belastungen und mechanische Beanspruchungen auftreten. Durch das Hutelement ist ferner eine elektrische Kontaktierung zu externen Anschlüssen ermöglicht. Aufgrund dessen, dass das Hutelement vorzugsweise ein elektrisch leitfähiges Material aufweist oder aus einem derartigen Material gefertigt ist, stellt es durch die umklammernde Anordnung an dem Sockelelement eine elektrische Verbindung her. Das Hutelement weist ferner vorzugsweise eine Hutfläche auf, die als elektrische Kontaktfläche für externe Anschlüsse dient. Die Hutfläche dient somit als Ausleitfläche. Unter dem Begriff "externe Anschlüsse" können im Sinne dieser Erfindung elektrische Kontaktierungen mit Bauteilen verstanden werden, die kein Teil eines leistungselektronischen Bauteils sind, auf dem das Sockelelement angeordnet ist. Somit ist durch das Hutelement eine zuverlässige Signalausleitung hergestellt, weshalb das Hutelement auch als "signalausleitendes Teilelement" bezeichnet werden kann.

Gemäß einer weiteren praktischen Ausführungsform weist das Hutelement mehrere radial auskragende Kreisringsegmente auf. Durch die radial auskragenden Kreisringsegmente ist eine zuverlässige mechanische und elektrische Kontaktierung des Hutelements an dem entsprechenden Teilelement des Sockelelements sichergesellt. Alternativ oder ergänzend ist mindestens eine Öffnung an dem Hutelement derart ausgebildet, dass bei montiertem Hutelement die Oberseite des Pilzkopfabschnitts zugänglich ist. Bei der mindestens einen Öffnung handelt es sich somit um eine Durchgangsöffnung für eine Verteilung und Weiterleitung von Signalleitungen, die an dem Pilzkopfabschnitt elektrisch kontaktierend angeordnet sind. Durch die mindestens eine Öffnung kann somit die Kontaktierung der Signalleitungen an dem Pilzkopfabschnitt bei gleichzeitig angeordnetem Hutelement ermöglicht werden. Mit anderen Worten wird der Pilzkopfabschnitt durch die mindestens eine Öffnung für Signalleitungen zugänglich gemacht.

Ferner kann es von Vorteil sein, wenn gemäß einer praktischen Ausführungsform mindestens ein Teilelement aus einem elektrisch isolierenden Werkstoff hergestellt ist. Insbesondere handelt es sich bei dem entsprechenden Teilelement um einen zylindrischen Schaftabschnitt. Ein zylindrischer Schaftabschnitt aus einem elektrisch isolierenden Werkstoff ermöglicht eine sichere elektrische Trennung, reduziert Leckströme und verbessert die Betriebssicherheit des Sockelelements. Gleichzeitig trägt er zur mechanischen Stabilität und thermischen Optimierung bei, wodurch die Gesamtperformance des Leistungselektronikmoduls verbessert wird. Bevorzugt handelt es sich bei dem elektrisch isolierenden Werkstoff um Kunststoff oder Keramik, wobei die Keramik aufgrund ihrer im Vergleich zu Kunststoff höheren Temperaturbeständigkeit und Dauerhaltbarkeit bevorzugt ist.

In einer praktischen Ausführungsform ist in einem Pilzkopfabschnitt eine Durchgangsöffnung ausgebildet. Vorzugsweise ist die Durchgangsöffnung in der Oberseite und besonders bevorzugt ergänzend in der Mitte des Pilzkopfabschnitts ausgebildet. Die Durchgangsöffnung ermöglicht ein Entweichen von Luft, wenn der Pilzkopfabschnitt auf einen Schaftabschnitt aufgesteckt wird, wodurch das Fügen dieser beiden Teilelemente erleichtert wird.

Alternativ oder ergänzend ist eine Oberfläche eines Pilzkopfabschnitts, insbesondere die Oberseite des Pilzkopfabschnitts, mit einer elektrisch leitfähigen Beschichtung oder einem elektrisch leitfähigen Zusatzelement versehen. Diese Ausführungsform verbessert oder schafft die elektrische Leitfähigkeit und schafft damit zusätzliche elektrische Kontaktierungsmöglichkeiten im Bereich des Pilzkopfabschnitts, insbesondere in der gleichen Kontaktierungsebene.

Gemäß einer praktischen Ausführungsform des Sockelelements mit einem Pilzkopfabschnitt ist an dem Pilzkopfabschnitt ein federelastisches Kontaktband und/oder eine Lageorientierungsstruktur ausgebildet. Die Ausgestaltung mit dem federelastischen Kontaktband ermöglicht eine Vereinfachung der elektrischen Kontaktierung, da diese bereits vor einem Anordnen des Sockelelements an bzw. auf dem leistungselektronischen Bauteil vorhanden ist und somit lediglich die elektrische Kontaktierung an dem anderen Ende des Kontaktbandes erfolgen muss.

Bei der Lageorientierungsstruktur handelt es sich insbesondere um einen Vorsprung und sich seitlich an den Vorsprung anschließende ebene Flächen, die eine Ausrichtung mittels eines Greifwerkzeuges ermöglichen. Wenn sowohl das federelastische Kontaktband als auch die Lageorientierungsstruktur vorgesehen sind, ist die Lageorientierungsstruktur vorzugweise gegenüber der Anbindungsstelle des Kontaktbandes angeordnet.

Ferner wird ein leistungselektronisches Bauteil mit einem Sockelelement beschrieben. Bei dem Sockelelement handelt es sich vorzugsweise um das vorstehend beschriebene Sockelelement.

Gemäß einer praktischen Ausführungsform des leistungselektronischen Bauteils ist zumindest ein Bereich, in dem das Sockelelement angeordnet ist, von einer Vergussmasse vergossen. Die Vergussmasse bietet einen zuverlässigen Schutz des leistungselektronischen Bauteils vor mechanischen Beanspruchungen. Vorzugsweise ist das gesamte leistungselektronische Bauteil von der Vergussmasse vergossen. Insbesondere, wenn das Sockelelement mit dem vorstehend erwähnten Hutelement ausgebildet ist, ist somit die Kontaktfläche des Hutelements vorzugsweise frei von der Vergussmasse und kann für eine elektrische Kontaktierung mit einem externen Anschluss herangezogen werden.

Die im Hinblick auf das Sockelelement aufgeführten Vorteile und bevorzugten Weiterbildungen sind sinngemäß auf das leistungselektronische Bauteil zu übertragen und umgekehrt.

Weitere praktische Ausführungsformen der Erfindung sind nachfolgend im Zusammenhang mit den Zeichnungen beschrieben. Es zeigen:
- Fig. 1: eine perspektivische sowie eine Halbschnitt-Darstellung eines erfindungsgemäßen Sockelelements gemäß einer ersten Ausführungsform;
- Fig. 2: eine perspektivische sowie eine Halbschnitt-Darstellung eines erfindungsgemäßen Sockelelements gemäß einer zweiten Ausführungsform;
- Fig. 3: eine perspektivische sowie eine Halbschnitt-Darstellung eines erfindungsgemäßen Sockelelements gemäß einer dritten Ausführungsform;
- Fig. 4a,b: eine perspektivische Darstellung des in Fig. 1 dargestellten Sockelelements mit kontaktierten Signalleitungen sowie im auf einem leistungselektronischen Bauteil montierten Zustand;
- Fig. 5a,b: eine perspektivische Darstellung des in Fig. 3 dargestellten Sockelelements mit kontaktierten Signalleitungen sowie im auf einem leistungselektronischen Bauteil montierten Zustand;
- Fig. 6a,b: eine perspektivische Darstellung des in Fig. 2 dargestellten Sockelelements mit kontaktierten Signalleitungen sowie im auf einem leistungselektronischen Bauteil montierten Zustand;
- Fig. 7: zwei perspektivische Darstellungen eines Sockelelements gemäß einer vierten Ausführungsform;
- Fig. 8: eine perspektivische Darstellung eines Teilelements eines Sockelelements gemäß einer alternativen Ausführungsform; und
- Fig. 9: ein mit einer Vergussmasse vergossenes leistungselektronisches Bauteil mit darauf montierten Sockelelementen.

In den Figuren sind gleiche bzw. gleichwirkende Bauteile stets mit den gleichen Bezugszeichen versehen.

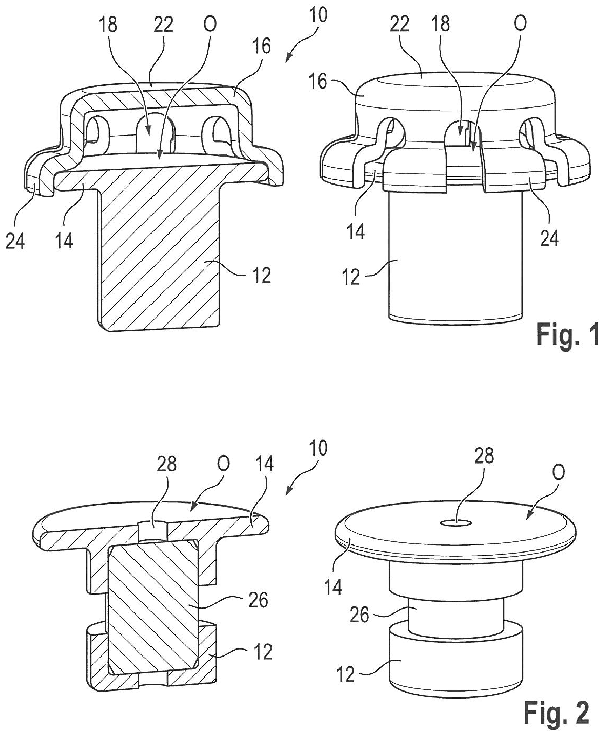

Das in Fig. 1 gezeigte Sockelelement 10 weist einen Schaftabschnitt 12 auf, der im Wesentlichen zylindrisch und mit einem runden Querschnitt ausgebildet ist. Ferner weist das Sockelelement 10 einen an dem Schaftabschnitt 12 endseitig auskragenden Pilzkopfabschnitt 14 auf. Im gezeigten Ausführungsbeispiel gemäß einer ersten Ausgestaltung des Sockelelements 10 weist dieses zusätzlich ein separates Hutelement 16 auf, das zumindest bereichsweise um den Pilzkopfabschnitt 14 umklammernd angeordnet ist. Das Sockelelement 10 gemäß Fig. 1 weist somit zwei Teilelemente auf: den Schaftabschnitt 12 mit dem monolithisch daran angeformten Pilzkopfabschnitt 14 als erstes Teilelement und das Hutelement 16 als zweites Teilelement.

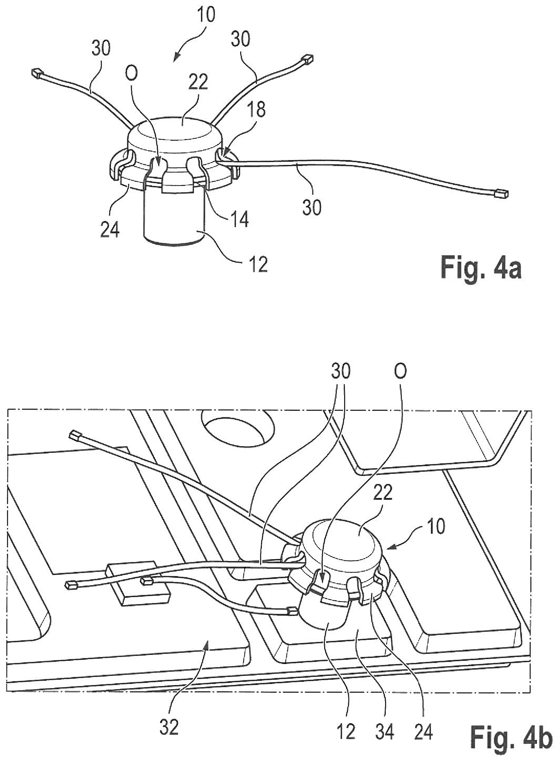

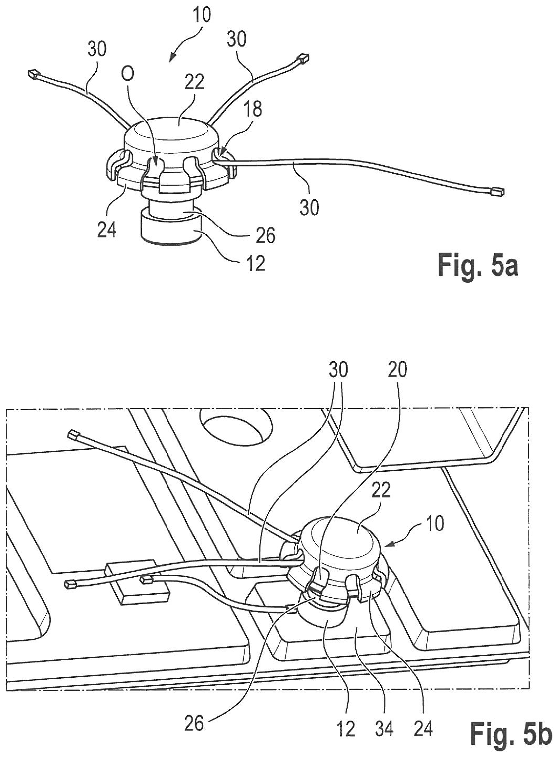

Ferner weist das Hutelement 16 mehrere Öffnungen 18 auf. Durch die Öffnungen 18 ist bei montiertem Hutelement 16 eine Oberseite O des Pilzkopfabschnitts 14 für eine elektrische Kontaktierung zugänglich (vgl. Fig. 4a,b oder 5a,b).

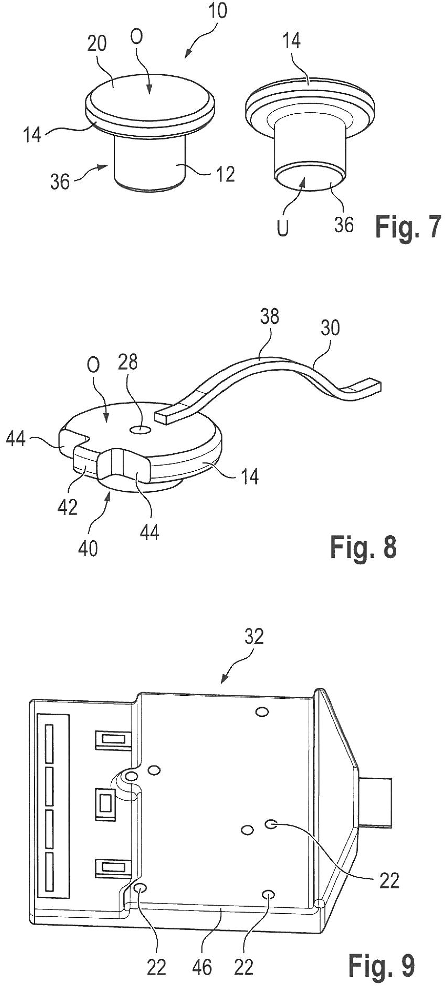

Des Weiteren weist das Hutelement 16 eine Kontaktierungsfläche 22 für eine elektrische Kontaktierung mit einem externen Anschluss (nicht dargestellt) auf. Die Kontaktierungsfläche 22 wird auch als Ausleitfläche bezeichnet und wird mit Bezug zur Fig. 9 noch näher erläutert.

Das Hutelement 16 weist ferner mehrere radial auskragende Kreisringsegmente 24 auf, mit denen die bereits erwähnte den Pilzkopfabschnitt 14 umklammernde Anordnung realisiert werden kann.

Fig. 2 zeigt eine perspektivische sowie eine Halbschnitt-Darstellung eines erfindungsgemäßen Sockelelements 10 gemäß einer zweiten Ausführungsform.

Das gezeigte Sockelelement 10 weist hierbei drei Teilelemente auf. Ein erstes Teilelement wird durch einen Teil des Schaftabschnitts 12 gebildet. Ein weiterer Teil mit daran monolithisch angeformtem Pilzkopfabschnitt 14 bildet das zweite Teilelement. Ein drittes Teilelement, welches durch ein elektrisches Isolationselement 26 ausgebildet wird, ist auf ein Ende des zylindrischen Schaftabschnitts 12 aufgesteckt. Mit anderen Worten bildet das elektrische Isolationselement 26 einen Teil des Schaftabschnitts 12 aus, wobei die beiden erwähnten anderen Teilelemente des gezeigten Sockelelements 10 auf die Enden des elektrischen Isolationselements 26 aufgesteckt sind. Ferner weisen der Schaftabschnitt 12 und der Pilzkopfabschnitt 14 ein elektrisch leitfähiges Material auf oder sind vorzugsweise aus einem derartigen Material gefertigt, während das elektrische Isolationselement 26 aus einem elektrisch isolierenden Werkstoff gefertigt ist. Somit sind die Teilelemente des Sockelelements 10 aus unterschiedlichen Werkstoffen gefertigt.

In dem Pilzkopfabschnitt 14 und insbesondere an der Oberseite O des Pilzkopfabschnitts 14 ist eine Durchgangsöffnung 28 ausgebildet. Die Durchgangsöffnung 28 dient einem Entweichen von Luft, wenn der Pilzkopfabschnitt 14 auf das elektrische Isolationselement 26 geschoben wird, so dass das Zusammenfügen dieser beiden Teilelemente erleichtert wird.

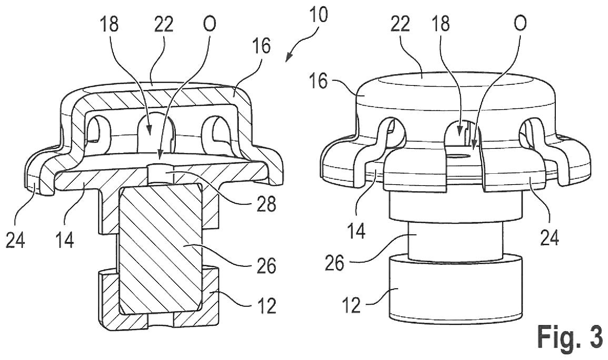

In Fig. 3 ist eine dritte Ausführungsform des erfindungsgemäßen Sockelelements 10 gezeigt. Darstellungsgemäß entspricht diese Ausführungsform des Sockelelements 10 einer Kombination aus den in Fig. 1 und 2 gezeigten Ausführungsformen. Somit weist das dargestellte Sockelelement 10 sowohl den geteilten Schaftabschnitt 12 mit dem elektrischen Isolationselement 26 gemäß der in Fig. 2 gezeigten Ausführungsform als auch das Hutelement 16 gemäß der in Fig. 1 gezeigten Ausführungsform auf.

Fig. 4a, b zeigt perspektivische Darstellungen des Sockelelements 10 gemäß der in Fig. 1 dargestellten Ausführungsform. Hierbei sind an dem Sockelelement 10 mehrere Signalleitungen 30 angeordnet und insbesondere mit der Oberseite O des Pilzkopfabschnitts 14 elektrisch kontaktiert. Um zu der Oberseite O des Pilzkopfabschnitts 14 zu gelangen, sind die Signalleitungen 30 durch die Öffnungen 18 des Hutelements 16 geführt.

Ein auf einem leistungselektronischen Bauteil 32 montiertes Sockelelement 10 gemäß dieser Ausführungsform ist in Fig. 4b dargestellt. Bei dem leistungselektronischen Bauteil 32 handelt es sich insbesondere um ein Leistungsmodul. Durch die Durchführung der Signalleitungen 30 zu der Oberseite O kann somit eine elektrische Kontaktierung von einer elektrisch leitenden Substratfläche 34 über den Schaftabschnitt 12 sowie über die Oberseite O zu den Signalleitungen 30 realisiert werden, die durch die Anordnung auf der Oberseite O eine höhergelegene Kontaktierungsebene, die auch als Verteilebene bezeichnet werden kann, ausbilden. Ferner kann durch das Hutelement 16 und insbesondere über die Kontaktierungsfläche 22 eine weitere Kontaktierung ermöglicht werden.

In Fig. 5a, b ist analog zu den in Fig. 4a, b gezeigten Darstellungen eine Kontaktierung des in Fig. 3 dargestellten Sockelelements 10 mit Signalleitungen 30 und auf einem leistungselektronischen Bauteil 32 gezeigt. Im Wesentlichen entspricht die gezeigte Anordnung der bereits in Fig. 4a, b erläuterten Anordnung. Der wesentliche Unterschied besteht darin, dass durch das elektrische Isolationselement 26 keine elektrische Kontaktierung zwischen der elektrisch leitenden Substratfläche 34 und dem Pilzkopfabschnitt 14 realisiert ist. Somit können über die Signalleitung 30 übertragene Signale lediglich über das Hutelement 16 zur Kontaktierungsfläche 22 übertragen werden.

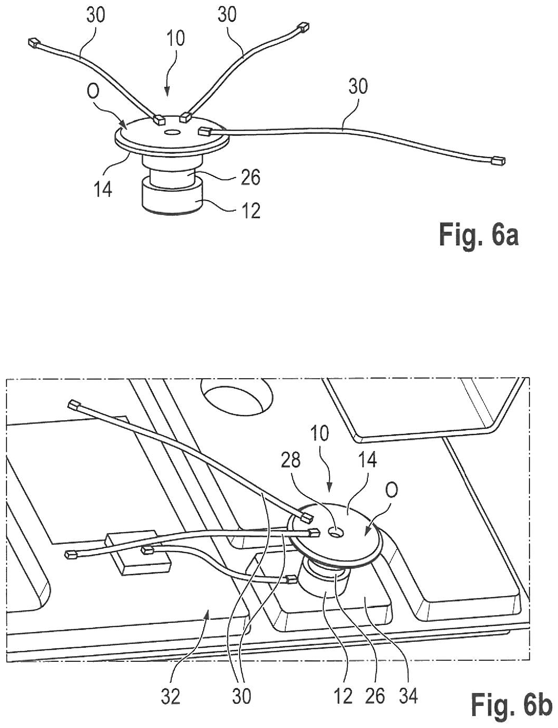

Ferner ist in Fig. 6a, b eine perspektivische Darstellung des in Fig. 2 dargestellten Sockelelements 10 mit kontaktierten Signalleitungen 30 sowie im auf einem leistungselektronischen Bauteil 32 montierten Zustand gezeigt. Insbesondere ist in der Fig. 6a die elektrische Kontaktierung der Signalleitungen 30 auf der Oberseite O des Pilzkopfabschnitts 14 zu erkennen. Die gezeigte Ausführungsform eignet sich insbesondere, wenn keine Kontaktierung zu einem externen Anschluss gewünscht ist und somit auch kein Hutelement 16 notwendig ist. Ansonsten entspricht die gezeigte Ausgestaltung des Sockelelements 10 der in Fig. 2 gezeigten Ausführungsform, so dass insoweit auf deren Beschreibung Bezug genommen wird.

Fig. 7 zeigt eine vierte Ausführungsform eines Sockelelements 10 in zwei perspektivischen Darstellungen. Diese Ausführungsform stellt eine besonders bevorzugte Ausführungsform dar. In dieser Ausführungsform ist das Element mit Schaftabschnitt 12 und Pilzkopfabschnitt 14 aus einem elektrisch isolierenden Werkstoff hergestellt, insbesondere aus Keramik. Dabei ist an der Oberseite O und an der Unterseite U jeweils eine elektrisch leitfähige Beschichtung 20, 36 aufgebracht. Dadurch können die Flächen an der Oberseite O des Pilzkopfabschnitts 14 und an der Unterseite U des Schaftabschnitts 12 unabhängig voneinander jeweils zur gleichzeitigen Kontaktierung und/oder zur Weiterleitung von Signalen innerhalb einer Ebene genutzt werden.

Darstellungsgemäß zeigt Fig. 8 ein an dem Pilzkopfabschnitt 14 angeordnetes federelastisches Kontaktband 38. Das federelastische Kontaktband 38 kann an dem Pilzkopfabschnitt 14 monolithisch angeformt sein oder beispielsweise mittels Schweißen stoffschlüssig an dem Pilzkopfabschnitt 14 angeordnet sein. Das federelastische Kontaktband 38 kann beispielsweise als Teil der oder als gesamte Signalleitung 30 dienen.

Ferner ist an dem in Fig. 8 dargestellten Pilzkopfabschnitt 14 eine Lageorientierungsstruktur 40 ausgebildet. Insbesondere weist die Lageorientierungsstruktur 40 einen Vorsprung 42 und sich seitlich anschließende ebene Flächen 44 auf, die eine Ausrichtung mittels eines (nicht dargestellten) Greifwerkzeuges ermöglichen. Wie in Fig. 8 gezeigt, ist die Lageorientierungsstruktur 40 vorzugweise gegenüber der Anbindungsstelle des Kontaktbandes 38 angeordnet.

Fig. 9 zeigt eine perspektivische Darstellung eines leistungselektronischen Bauteils 32, welches von einer Vergussmasse 46 vergossen ist. Lediglich die bereits erwähnten Kontaktierungsflächen 22 der Hutelemente 16 sind frei von der Vergussmasse 46, so dass über diese eine elektrische Kontaktierung mit einem externen Anschluss (nicht dargestellt) ermöglicht ist.

Die in der vorliegenden Beschreibung, in den Zeichnungen sowie in den Ansprüchen offenbarten Merkmale der Erfindung können sowohl einzeln als auch in beliebigen Kombinationen für die Verwirklichung der Erfindung in ihren verschiedenen Ausführungsformen wesentlich sein. Die Erfindung kann im Rahmen der Ansprüche und unter Berücksichtigung der Kenntnisse des zuständigen Fachmanns variiert werden.

### Bezugszeichenliste

- 10: Sockelelement
- 12: Schaftabschnitt
- 14: Pilzkopfabschnitt
- 16: Hutelement
- 18: Öffnungen
- 20: elektrisch leitfähige Beschichtung
- 22: Kontaktierungsfläche
- 24: Kreisringsegmente
- 26: elektrisches Isolationselement
- 28: Durchgangsöffnung
- 30: Signalleitung
- 32: leistungselektronisches Bauteil
- 34: elektrisch leitende Substratfläche
- 36: elektrisch leitfähige Beschichtung
- 38: Kontaktband
- 40: Lageorientierungsstruktur
- 42: Vorsprung
- 44: ebene Flächen
- 46: Vergussmasse

- O: Oberseite
- U: Unterseite

## Patentansprüche

1. Sockelelement (10) zur Signalkontaktierung in einem leistungselektronischen Bauteil (32), wobei das Sockelelement (10) einen Schaftabschnitt (12) und einen endseitig radial auskragenden Pilzkopfabschnitt (14) aufweist, **dadurch gekennzeichnet, dass** das Sockelelement (10) aus mindestens zwei Teilelementen und/oder aus mindestens zwei Werkstoffen gefertigt ist.

2. Sockelelement (10) nach dem vorstehenden Anspruch, **dadurch gekennzeichnet, dass** zwei oder drei Teilelemente separat hergestellt und fest miteinander verbunden sind.

3. Sockelelement (10) nach dem vorstehenden Anspruch, **dadurch gekennzeichnet, dass** ein Teilelement den Schaftabschnitt (12) umfasst und mindestens ein weiteres Teilelement auf ein Ende des Schaftabschnitts (12) aufgesteckt ist.

4. Sockelelement (10) nach einem der beiden vorstehenden Ansprüche, **dadurch gekennzeichnet, dass** ein Teilelement als ein separates Hutelement (16) ausgebildet ist und zumindest bereichsweise um den Pilzkopfabschnitt (14) eines anderen Teilelements umklammernd angeordnet ist.

5. Sockelelement (10) nach dem vorstehenden Anspruch, **dadurch gekennzeichnet, dass** das Hutelement (16) mehrere radial auskragende Kreisringsegmente (24) aufweist und/oder mindestens eine Öffnung (18) an dem Hutelement (16) derart ausgebildet ist, dass bei montiertem Hutelement (16) die Oberseite (O) des Pilzkopfabschnitts (14) zugänglich ist.

6. Sockelelement (10) nach einem der Ansprüche 2 bis 5, **dadurch gekennzeichnet, dass** mindestens ein Teilelement aus einem elektrisch isolierenden Werkstoff hergestellt ist.

7. Sockelelement (10) nach einem der vorstehenden Ansprüche, **dadurch gekennzeichnet, dass** in dem Pilzkopfabschnitt (14) eine Durchgangsöffnung (28) ausgebildet ist und/oder zumindest eine Oberfläche des Pilzkopfabschnitts (14) mit einer elektrisch leitfähigen Beschichtung (20, 36) oder einem elektrisch leitfähigen Zusatzelement versehen ist.

8. Sockelelement (10) nach einem der vorstehenden Ansprüche mit einem Pilzkopfabschnitt (14), **dadurch gekennzeichnet, dass** an dem Pilzkopfabschnitt (14) ein federelastisches Kontaktband (38) und/oder eine Lageorientierungsstruktur (40) ausgebildet ist.

9. Leistungselektronisches Bauteil (32) mit einem Sockelelement (10) nach einem der vorstehenden Ansprüche.

10. Leistungselektronisches Bauteil (32) nach dem vorstehenden Anspruch, **dadurch gekennzeichnet, dass** zumindest ein Bereich, in dem das Sockelelement (10) angeordnet ist, von einer Vergussmasse (46) vergossen ist.
